# EUROPEAN PATENT SPECIFICATION

(11) **EP 4 040 625 B1**
(45) Date of publication and mention of the grant of the patent: **04.10.2023**
(21) Application number: 21218058.2
(22) Date of filing: 29.12.2021
(51) Int. Cl.: H02J 7/00, H02J 50/00, H05K 7/20

(54) **WIRELESS CHARGER**
DRAHTLOSES LADEGERÄT
CHARGEUR SANS FIL

(30) Priority: 09.02.2021 CN 202110177984
(43) Date of publication of application: 10.08.2022
(73) Proprietor: Huawei Digital Power Technologies Co., Ltd., Shenzhen, Guangdong 518043 (CN)
(72) Inventor: WU, Hao, Shenzhen, 518129 (CN); LI, Quanming, Shenzhen, 518129 (CN); CHEN, Jun, Shenzhen, 518129 (CN); HUI, Xiaowei, Shenzhen, 518129 (CN)
(74) Representative: Goddar, Heinz J.

(56) References cited:
- CN-U- 208 401 601
- CN-U- 208 738 898
- CN-U- 211 981 547
- KR-A- 20190 006 239
- US-A1- 2020 091 755

## Description

### TECHNICAL FIELD

This application relates to the field of wireless charging technologies, and in particular, to a wireless charger.

### BACKGROUND

With rapid development of electronic devices such as smartphones, wireless chargers are widely used in people's life and office fields as auxiliary charging apparatuses. Whether the wireless charger can perform good heat dissipation directly affects charging power and a charging speed of the electronic device. However, a conventional wireless charger has a poor heat dissipation capability.
US 2020/0091755 A1 discloses an inductive charging dock with active cooling that enable the dock to wireless charge an electronic device at an improved charging speed.
CN 208738898 U provides a wireless charger for wireless charging of a mobile electronic device.

### SUMMARY

The invention is defined by the subject-matter of the independent claims, wherein further embodiments are defined in the dependent claims.

Embodiments of this application provide a wireless charger. The wireless charger has a good heat dissipation capability and good reliability.

This application provides a wireless charger, where the wireless charger includes:
a housing, where the housing has a first air inlet, a first air outlet, a second air inlet and a second air outlet, a heat dissipation air channel that communicates with the first air inlet and the first air outlet and that is located inside the housing is formed between the first air inlet and the first air outlet, and a cooling air channel that communicates with the second air inlet and the second air outlet and that is located inside the housing is formed between the second air inlet and the second air outlet;
a circuit board component, where the circuit board component is located in the heat dissipation air channel; and
a heat conduction structure, where the heat conduction structure includes a contact part and a connection part that are connected to each other, at least a part of the contact part is exposed to an outer surface of the housing, the contact part is configured to be in contact with a to-be-charged device, the connection part is located inside the housing and is in contact with the heat dissipation air channel, the contact part, the outer surface of the housing, and the to-be-charged device cooperate to form a ventilation channel, and the ventilation channel communicates with the heat dissipation air channel;
a heat dissipation structure, wherein the heat dissipation structure is located in the heat dissipation air channel and is connected to the connection part, the heat dissipation structure is adjacent to the circuit board component, and the heat conduction structure is configured to conduct heat; and
wherein the heat dissipation air channel and the cooling air channel are respectively located on two opposite sides of the contact part of the heat conduction structure.

It may be understood that, the first air inlet may be understood as an opening for natural wind to enter the heat dissipation air channel from an environment outside the wireless charger, and the first air outlet may be understood as an opening for air that carries heat of the wireless charger and the to-be-charged device to flow from the heat dissipation air channel into an external environment. The heat dissipation air channel communicates with the first air inlet and the first air outlet, so that the heat dissipation air channel, the first air inlet, and the first air outlet can cooperate with each other to dissipate heat for a back surface of the to-be-charged device. The back surface of the to-be-charged device may be understood as a surface that faces away from a user when the user holds a mobile phone.

In other words, cold air enters the wireless charger through the first air inlet. When flowing in the heat dissipation air channel in the wireless charger, the cold air carries the heat generated by the wireless charger and the to-be-charged device and becomes hot air. The hot air flows out of the wireless charger through the first air outlet, and flows into the external environment. In this way, the cold air and the hot air circulate alternately and periodically, to complete uninterrupted heat exchange between the wireless charger and the external environment, and ensure that the wireless charger always has good heat conduction performance.

The heat conduction structure extends from the outer surface of the housing to the inside of the housing. A part of the heat conduction structure that is exposed to the outside of the housing is in contact with the to-be-charged device, and a part of the heat conduction structure that is located in the housing is in contact with the heat dissipation air channel. Therefore, the heat of the to-be-charged device can be transferred to the inside of the wireless charger through heat conduction by the heat conduction structure, to dissipate heat for the to-be-charged device. In other words, at least a part of the contact part is used as a part of the heat conduction structure that is located outside the housing, and can be directly in contact with the to-be-charged device to conduct the heat of the to-be-charged device to the heat conduction structure. The connection part is used a part of the heat conduction structure that is located in the housing, and can be directly in contact with the heat dissipation air channel to further conduct the heat of the to-be-charged device to the inside of the wireless charger, so as to fully use a heat conduction capability of the wireless charger.

In other words, the heat of the to-be-charged device may be transferred to the inside of the wireless charger by using the heat conduction structure, and is dissipated through the heat dissipation air channel of the wireless charger, so that the wireless charger can dissipate heat for the to-be-charged device. In case of the disposition, the heat conduction capability of the wireless charger can be improved, and a possibility that a temperature of the to-be-charged device rises within short time is minimized based on the heat conduction capability and a heat dissipation function of the to-be-charged device, so that the to-be-charged device has good thermal equilibrium, and the wireless charger can maintain good working performance. In other words, the wireless charger can provide good heat dissipation performance for the to-be-charged device, so that thermal equilibrium of the to-be-charged device does not easily affect charging power of the wireless charger. Therefore, when the wireless charger has same charging power, the temperature of the to-be-charged device can be greatly lowered. In other words, when the wireless charger dissipates heat for heating points under a same condition, namely, when the wireless charger achieves a same heat dissipation objective, a heat dissipation capability of the wireless charger can be greatly improved. This helps better improve the charging power of the wireless charger and user experience.

In a working process of the wireless charger, an electronic element used as a heating element generates a large amount of heat, and therefore forms a heating point at a corresponding position inside the wireless charger. A temperature of the heating point is high. If the heat generated by the heating point is not effectively dissipated in a timely manner, working performance of the wireless charger is directly affected. For example, if local overheating occurs, the wireless charger fails. In addition, a temperature of the housing at a position corresponding to the heating point is also correspondingly high. Consequently, local overheating occurs in the housing, and user experience is severely affected. In other words, thermal equilibrium of the wireless charger also directly affects the working performance of the wireless charger. Therefore, the circuit board component is disposed in the heat dissipation air channel, so that the wireless charger can dissipate heat for the wireless charger. In other words, the wireless charger can dissipate heat for both the wireless charger and the to-be-charged device, so that the heat of the wireless charger and the to-be-charged device can be effectively dissipated through the heat dissipation air channel, and the entire wireless charger has a good heat conduction temperature difference and good heat transfer efficiency. This effectively improves heat conduction performance of the wireless charger.

In addition, the contact part, the outer surface of the housing, and the to-be-charged device can cooperate to form the ventilation channel that communicates with the heat dissipation air channel. Therefore, air in the external environment can be conveniently and quickly guided into the ventilation channel. This has a good guiding function. In addition, an area in which the housing of the wireless charger and a housing of the to-be-charged device are in contact with air can be greatly improved without excessively occupying space in the housing of the wireless charger. This further plays a role of dissipating heat for the wireless charger and the to-be-charged device.

In a possible implementation, the contact part includes a heat conduction surface that is in contact with the to-be-charged device, and there is a height difference between the heat conduction surface and the outer surface of the housing.

"There is a height difference" may be understood as follows: The contact part is totally protruded from a heat dissipation surface, or a part of the contact part is built in the housing, and a part is exposed to a heat dissipation surface.

Therefore, the height difference between the heat conduction surface and the heat dissipation surface can be flexibly adjusted based on an actual requirement, so that the formed ventilation channel can guide external air to the inside of the wireless charger to a maximum degree. This effectively improves the heat dissipation capability of the wireless charger.

In a possible implementation, the housing includes the heat dissipation surface that faces the to-be-charged device, the contact part includes a first side part and a second side part, the first side part and the second side part are protruded from the heat dissipation surface and are respectively located on two sides of the heat dissipation surface, and a gap is disposed between the first side part and the second side part.

For example, both the first side part and the second side part extend from a top of a body to a bottom of the body. For example, the first side part and the second side part may be in a long strip shape, and are respectively located on two edges of the heat dissipation surface.

Therefore, the heat of the to-be-charged device can be conducted without excessively occupying a surface area of the housing. In addition, the to-be-charged device can also be in no direct contact with the wireless charger by using the gap of the contact part, so that the ventilation channel can be formed between the to-be-charged device and the wireless charger to expand a heat dissipation area. This helps further improve the heat conduction capability and heat dissipation efficiency of the wireless charger.

In a possible implementation, the contact part and the connection part are an integral structure, and the integral structure is flexible.

For example, the contact part and the connection part are an integral structure. In other words, the entire heat conduction structure may be an integral structure. The heat conduction structure produced by using an integral structure has fewer processing steps. This can effectively reduce production costs and time costs, and improve processing production efficiency of the wireless charger. In addition, the heat conduction structure may further be flexible, so that the heat conduction structure is bendable. In other words, the contact part can be bent relative to the connection part (which may be understood as that the connection part can be bent relative to the contact part), so that a form of the contact part can change with an elevation angle of the housing, to flexibly adapt to an application requirement existing when the elevation angle of the housing is changeable. For example, the heat conduction structure may be a heat pipe or a vapor chamber. However, it should be understood that a heat conduction material that has high heat conduction performance and that can effectively conduct the heat of the to-be-charged device may be applied to the wireless charger provided in this embodiment of this application. This is not strictly limited.

The wireless charger includes a heat dissipation structure, the heat dissipation structure is located in the heat dissipation air channel and is connected to the connection part, the heat dissipation structure is adjacent to the circuit board component, and the heat conduction structure conducts heat, so that the heat dissipation structure dissipates heat for the circuit board component and the to-be-charged device.

It may be understood that, because the heat dissipation structure is connected to the heat conduction structure, heat of the heat conduction structure may be dissipated by using the heat dissipation structure, so that the heat dissipation structure can dissipate heat for both the to-be-charged device and the wireless charger. This diversifies use performance of the heat dissipation structure, so that the heat dissipation capability of the wireless charger can be greatly improved. This helps better improve the charging power of the wireless charger and user experience.

The housing has a second air inlet and a second air outlet, a cooling air channel that communicates with the second air inlet and the second air outlet and that is located inside the housing is formed between the second air inlet and the second air outlet. In a possible implementation, the cooling air channel is located on a side of the contact part that faces away from the heat dissipation structure; and
the heat dissipation structure includes a semiconductor cooling member and a first heat sink, the semiconductor cooling member includes a cold surface, and the first heat sink is located between the cold surface and the contact part.

It may be understood that, the heat conduction structure conducts the heat generated by the to-be-charged device to the cold surface of the semiconductor cooling member, the cold surface can absorb heat to lower a temperature, and a heat dissipation fin of a second heat sink disposed on the cold surface can continuously perform cooling. In this way, wind that enters the cooling air channel through the second air outlet can be cooled after a temperature of the wind is further lowered under an action of the heat dissipation fin of the second heat sink, so that the cooled cold air can flow out through the second air outlet to blow to the to-be-charged device.

In a possible implementation, the heat dissipation structure further includes the second heat sink, the semiconductor cooling member further includes a hot surface disposed oppositely to the cold surface, and the second heat sink is located in the heat dissipation air channel and is connected to the hot surface.

It may be understood that, the heat absorbed by the cold surface can be released by using the hot surface, and the heat is effectively dissipated under an action of a heat dissipation fin of the first heat sink, so that hot air can flow in the heat dissipation air channel and is brought out of the wireless charger, to dissipate heat for that wireless charger through heat exchange.

In a possible implementation, the housing includes the body and a base, the bottom of the body is connected to the base, a surface of the body that faces the to-be-charged device is the heat dissipation surface, the base includes a bearing surface connected to the heat dissipation surface, and the bearing surface is provided with a perforation; and
the contact part extends from the top of the body to the bottom of the body, the contact part passes through the perforation, the contact part is connected to the connection part located inside the base, and the contact part and the connection part are disposed at an angle.

In other words, a part of the contact part may be disposed outside the housing, and a part may be disposed inside the housing. Therefore, this can conveniently and quickly connect the to-be-charged device located outside the housing and the heat dissipation structure located inside the housing, so that the heat of the to-be-charged device can be transferred to the wireless charger and is dissipated by using the heat dissipation structure. The contact part and the connection part are disposed at an angle. This can fully adapt to an appearance form of the wireless charger, and well adapt to narrow space arrangement inside the housing of the wireless charger, so that application requirements in a plurality of space configurations are met, and flexibility is strong. This helps adapt to a miniaturization development trend of the wireless charger.

In a possible implementation, the body is capable of rotating relative to the base and driving the contact part to be bent relative to the connection part.

It should be understood that, when the elevation angle of the wireless charger is adjustable, the body is capable of rotating relative to the base and driving the contact part to be bent relative to the connection part. An included angle between the contact part and the connection part can adaptively change with an included angle between the body and the base. Therefore, in a process of adjusting the elevation angle of the wireless charger, the heat conduction structure can always be stably connected between the to-be-charged device and the heat dissipation structure, and reliability is good.

In a possible implementation, first accommodation space is disposed in the body, second accommodation space communicating with the first accommodation space is disposed in the base, and the connection part, the circuit board component, the heat dissipation structure, and the heat conduction structure are all located in the second accommodation space;
the first air inlet is located on the heat dissipation surface, the heat dissipation air channel extends from the first accommodation space to the second accommodation space, and the first air outlet is located on a side surface of the base; and
the wireless charger further includes a first fan, the first fan is located in the first accommodation space and corresponds to the first air inlet, and air that enters the heat dissipation air channel through the first air inlet is driven by the first fan to flow out through the first air outlet to dissipate heat for the back surface of the to-be-charged device, where the back surface of the to-be-charged device is a surface that faces the heat dissipation surface.

It may be understood that, because the heat dissipation air channel communicates with the first air inlet and the first air outlet, the heat dissipation air channel can extend from the first accommodation space to the second accommodation space. In other words, at least a part of the first accommodation space and at least a part of the second accommodation space form the heat dissipation air channel, and the heat dissipation air channel extends from the body to the base, so that the heat dissipation air channel is evenly distributed at each part of the housing. This helps improve temperature balance performance of the housing, so that the housing has a good heat conduction temperature difference and good heat dissipation efficiency, to further improve the heat dissipation capability of the wireless charger.

The first fan is a power source that enables air in the wireless charger to flow, is disposed in the heat dissipation air channel of the housing and corresponds to the first air inlet, and may be electrically connected to the circuit board component. Therefore, air that enters the wireless charger may be driven by the first fan to flow in the heat dissipation air channel. This helps improve air flow and heat dissipation performance of the wireless charger. For example, the first fan may be but is not limited to a centrifugal fan, an axial fan, and a piezoelectric fan.

In a possible implementation, the second air inlet is located on a bottom surface of the base, the cooling air channel is formed in the second accommodation space, and the second air outlet is located on the bearing surface of the base; and
the wireless charger further includes a second fan, the second fan is located in the second accommodation space and corresponds to the second air inlet, and the second fan and the first heat sink cooperate, so that air that enters the second accommodation space through the second air inlet is cooled and then flows out through the second air outlet to dissipate heat for a front surface of the to-be-charged device, where the front surface of the to-be-charged device is a surface that faces away from the heat dissipation surface.

It may be understood that, because the cooling air channel communicates with the second air inlet and the second air outlet, the cooling air channel is located in the second accommodation space. In other words, at least a part of the second accommodation space forms the cooling air channel, and the cooling air channel extends from one end of the base to the other end of the base, so that the cooling air channel is evenly distributed inside the base. This helps air that is cooled in the cooling air channel stably and efficiently blow to the to-be-charged device, to further lower the temperature of the to-be-charged device, and better improve user experience.

The second fan is a power source that enables air in the wireless charger to flow, is disposed in the cooling air channel of the housing and corresponds to the second air inlet, and may be electrically connected to the circuit board component. Therefore, air that enters the wireless charger may be driven by the second fan to flow in the cooling air channel. This helps improve air flow and heat dissipation performance of the wireless charger. For example, the second fan may be but is not limited to a centrifugal fan, an axial fan, and a piezoelectric fan.

In a possible implementation, the heat dissipation structure further includes a coil component, the coil component is located inside the first accommodation space, and an orthogonal projection of the coil component on the heat dissipation surface falls within a range of an orthogonal projection of a gap region between the first side part and the second side part on the heat dissipation surface.

Therefore, the first side part and the second side part can be disposed without preventing the coil component from transmitting a power signal, so that an induction range of the coil component is larger, and the charging power of the wireless charger can be optimized.

In a possible implementation, the wireless charger further includes a fin, and the fin is located on an inner wall of the first accommodation space and/or an inner wall of the second accommodation space.

Therefore, this can effectively increase the heat dissipation area, enhance heat dissipation, and improve heat dissipation efficiency of the wireless charger. It should be noted that the fin and the inner wall may be an integral structure. The fin may have different fin types, for example, a pin-shaped fin, a fan-shaped fin, and a ring-shaped fin. This is not strictly limited in this embodiment of this application.

### BRIEF DESCRIPTION OF DRAWINGS

FIG. 1 is a schematic cross-sectional diagram of a wireless charger according to an embodiment of this application;
FIG. 2 is a schematic cross-sectional diagram of applying a wireless charger to a to-be-charged device according to an embodiment of this application;
FIG. 3 is a schematic cross-sectional diagram of a wireless charger from a perspective according to an embodiment of this application;
FIG. 4 is a simplified schematic diagram of applying a wireless charger to a to-be-charged device according to an embodiment of this application, where the to-be-charged device is vertically placed;
FIG. 5 is another simplified schematic diagram of applying a wireless charger to a to-be-charged device according to an embodiment of this application, where the to-be-charged device is horizontally placed;
FIG. 6 is a schematic diagram of a partial structure of a wireless charger according to an embodiment of this application; and
FIG. 7 is another schematic diagram of a partial structure of a wireless charger according to an embodiment of this application.

### DESCRIPTION OF EMBODIMENTS

For ease of understanding, the following first explains terms in the embodiments of this application.

The term "and/or" describes only an association relationship for describing associated objects and represents that three relationships may exist. For example, A and/or B may represent the following three cases: Only A exists, both A and B exist, and only B exists.

"A plurality of" means "two or more".

"Fasten" should be understood in a broad sense. For example, "A is fastened to B" may be that A is directly connected to B and a relative position existing after the connection does not change, or may be that A is indirectly connected to B by using an intermediate medium and a relative position existing after the connection does not change.

The following clearly describes specific implementations of this application in detail with reference to the accompanying drawings.

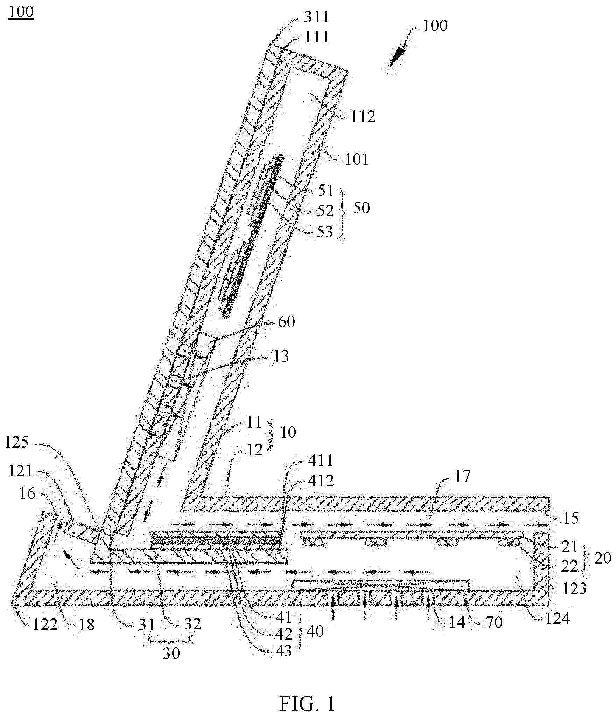

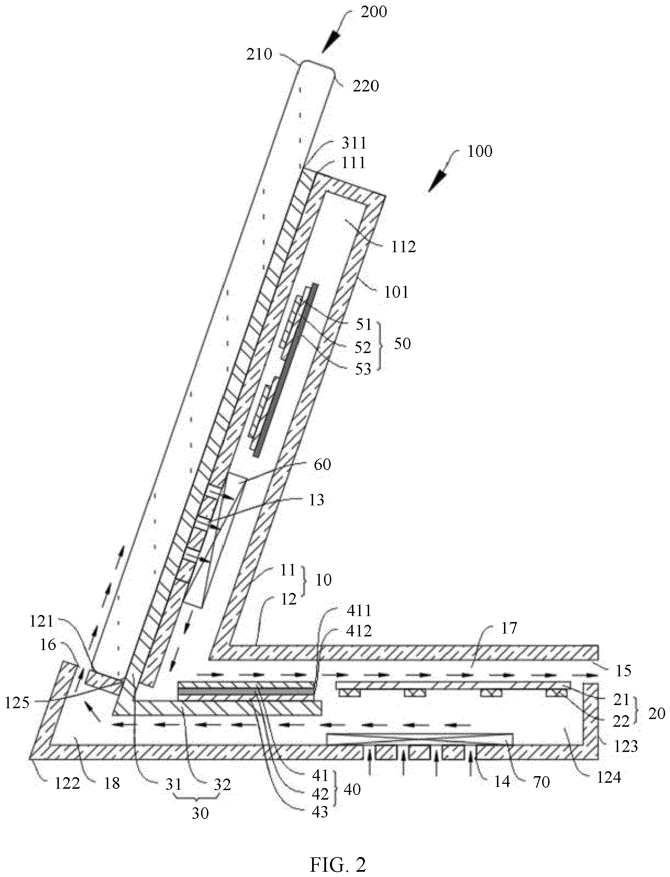

Refer to FIG. 1 and FIG. 2. An embodiment of this application provides a wireless charger 100. The wireless charger 100 may be configured, based on a requirement, to provide rated wireless charging power (such as Max 40 W or Max 50 W). If allowed, a volume of the wireless charger 100 may be as small as possible, and the wireless charger 100 can support slow charging and fast charging. The wireless charger 100 may be but is not limited to a mobile phone charger or an on-board charger.

It may be understood that the wireless charger 100 is an apparatus for charging a to-be-charged device 200 by using an electromagnetic induction principle. A transmit coil is disposed in the wireless charger 100 used as a transmit end, and a receive coil is disposed in the to-be-charged device 200 used as a receive end, and energy coupling is performed between the transmit coil and the receive coil, so that electric energy can be transmitted between the wireless charger 100 and the to-be-charged device 200. In other words, the transmit coil sends an electromagnetic signal to the outside, and the receive coil receives the electromagnetic signal and converts the electromagnetic signal into a current, to achieve a wireless charging purpose.

In addition, the wireless charger 100 may further charge different types of to-be-charged devices 200, to minimize a possibility that a user needs to bring a plurality of power adapters and power cables when the user goes out. This effectively improves portability of the wireless charger 100.

For example, when the to-be-charged device 200 needs to be charged, the to-be-charged device 200 may be placed on the wireless charger 100, so that the wireless charger 100 charges the to-be-charged device 200. When the wireless charger 100 charges the to-be-charged device 200, the wireless charger 100 may be in a vertical state, or may be in a horizontal state. Therefore, this can diversify a use mode of the wireless charger 100 and improve user experience.

For ease of understanding, an example in which the wireless charger 100 charges the to-be-charged device 200 such as a mobile phone that has a wide range of users and rich application scenarios is used for description, but imposes no limitation.

It may be understood that, in a working process of the wireless charger 100, the user may use the to-be-charged device 200 (for example, a voice call, a video chat, audio/video play, or software office). Due to use of the to-be-charged device 200, a temperature of the to-be-charged device 200 may rise to a degree within short time. If a temperature of a part of the to-be-charged device 200 rises, a charging speed of the wireless charger 100 is affected, and charging power of the wireless charger 100 is limited. In other words, thermal equilibrium of the to-be-charged device 200 directly affects working performance of the wireless charger 100, and consequently limits a further improvement of power of the wireless charger 100. Therefore, heat dissipation performance provided by the wireless charger 100 for the to-be-charged device 200 is particularly important.

Based on this, the wireless charger 100 provided in this embodiment of this application can overcome a heat dissipation layout limitation in a conventional technology, and improve a heat dissipation capability of the wireless charger 100. In addition, the power of the wireless charger 100 can be further improved by optimizing a heat conduction capability of the wireless charger 100, and reliability is good.

It should be understood that a wireless charging function of the wireless charger 100 may flexibly support different models of mobile phones, and same or different charging power may be provided for different models of mobile phones. For example, a maximum of 40 W wireless charging power may be provided for a mobile phone with a model C1, a maximum of 15 W wireless charging power may be provided for mobile phones with models C2 and C3, and a maximum of 10 W wireless charging power may be provided for a mobile phone with a model C4. Therefore, the wireless charger 100 can adapt to more models of to-be-charged devices 200. This effectively improves convenience of the wireless charger 100.

Refer to FIG. 1 and FIG. 2. The wireless charger 100 includes a housing 10, a circuit board component 20, a heat conduction structure 30, a heat dissipation structure 40, a coil component 50, a first fan 60, and a second fan 70. Pointing directions of arrows in FIG. 1 and FIG. 2 are directions in which air flows.

It should be noted that FIG. 1 and FIG. 2 are merely intended to schematically describe a connection relationship among the housing 10, the circuit board component 20, the heat conduction structure 30, the heat dissipation structure 40, the coil component 50, the first fan 60, and the second fan 70, and are not intended to specifically limit connection positions, specific structures, and quantities of the devices. The structure shown in this embodiment of this application does not constitute a specific limitation on the wireless charger 100. In some other embodiments of this application, the wireless charger 100 may include more or fewer components than those shown in the figure, or combine some components, or split some components, or have different component arrangements. The components shown in the figures may be implemented by using hardware, software, or a combination of software and hardware.

Refer to FIG. 1 and FIG. 2. The housing 10 is a housing structure of the wireless charger 100, and can accommodate and encapsulate various components of the wireless charger 100, so that various components of the wireless charger 100 are protected from external dust, moisture, and the like. Therefore, the housing 10 has a good protection function.

When the wireless charger 100 is a horizontal charger, internal components of the wireless charger 100 may be distributed in a centralized form. Therefore, the entire housing 10 may present a structural form that enables the to-be-charged device 200 to be horizontally placed. Horizontal placement may be understood as using ground is a reference surface, and the to-be-charged device 200 is disposed in parallel with the ground. When the wireless charger 100 is a vertical charger, internal components of the wireless charger 100 may be distributed in a dispersed form. Therefore, the entire housing 10 may present a structural form that enables the to-be-charged device 200 to be inclinedly placed. Inclined placement may be understood as using ground is a reference surface, and the to-be-charged device 200 is inclined relative to the ground.

The housing 10 has a first air inlet 13, a second air inlet 14, a first air outlet 15, a second air outlet 16, a heat dissipation air channel 17, and a cooling air channel 18. The first air inlet 13, the second air inlet 14, the first air outlet 15, and the second air outlet 16 are all openings disposed on an outer surface 101 of the housing 10. For example, the opening may be a hole-like structure disposed on the outer surface 101 of the housing 10, or may be a groove-like structure disposed on the outer surface 101 of the housing 10. The heat dissipation air channel 17 and the cooling air channel 18 are disposed inside the housing 10, and the heat dissipation air channel 17 and the cooling air channel 18 are respectively located on two opposite sides of a contact part 31 of the heat conduction structure 30. The heat dissipation air channel 17 communicates with the first air inlet 13 and the first air outlet 15, so that the heat dissipation air channel 17, the first air inlet 13, and the first air outlet 15 can cooperate with each other to dissipate heat for a front surface 220 of the to-be-charged device 200. The front surface 220 of the to-be-charged device 200 may be understood as a surface that faces away from the user when the user holds the mobile phone. The cooling air channel 18 communicates with the second air inlet 14 and the second air outlet 16, so that the cooling air channel 18, the second air inlet 14, and the second air outlet 16 can cooperate with each other to dissipate heat for the front surface 210 of the to-be-charged device 200. The front surface 210 of the to-be-charged device 200 may be understood as a surface that faces the user when the user holds the mobile phone.

In other words, the first air inlet 13 may be understood as an opening for natural wind to enter the wireless charger 100 from an environment outside the wireless charger 100, and the first air outlet 15 may be understood as an opening for air that carries heat of the wireless charger 100 and the to-be-charged device 200 to flow from the heat dissipation air channel 17 into an external environment. The second air inlet 14 may be understood as an opening for natural wind to enter the wireless charger 100 from an environment outside the wireless charger 100, and the second air outlet 16 may be understood as an opening for air that is cooled in the cooling air channel 18 to flow out of the wireless charger 100 and blow to the front surface 210 of the to-be-charged device 200.

In other words, a part of cold air enters the wireless charger 100 through the first air inlet 13. When flowing in the heat dissipation air channel 17 in the wireless charger 100, the cold air carries the heat generated by the wireless charger 100 and the to-be-charged device 200 and becomes hot air. The hot air flows out of the wireless charger 100 through the first air outlet 15, and flows into the external environment. In this way, the cold air and the hot air circulate alternately and periodically, to complete uninterrupted heat exchange between the wireless charger 100 and the external environment, and ensure that the wireless charger 100 always has good heat conduction performance. Another part of the cold air enters the wireless charger 100 through the second air inlet 14. When flowing in the cooling air channel 18 in the wireless charger 100, the cold air is cooled after a temperature of the cold air is further lowered. The cooled air flows out of the power adapter through the second air outlet 16, and blows to the front surface 210 of the to-be-charged device 200. In this case, the cold air circulates periodically, so that wind uninterruptedly blows to the front surface 210 of the to-be-charged device 200 to perform heat dissipation.

The circuit board component 20 is a core component of the wireless charger 100, and is accommodated in the heat dissipation air channel 17 inside the housing 10, so that important components of the wireless charger 100 can be integrated together, to play respective roles. The circuit board component 20 may include a circuit board 21 and a plurality of electronic elements 22 disposed on the circuit board 21. The circuit board 21 may be understood as a medium for bearing the electronic element 22. The circuit board 21 may provide functions such as an electric connection, protection, support, heat dissipation, and assembling for the electronic element 22, and may also be used as a heat conduction member to conduct heat of the electronic element 22. The electronic element 22 may be understood as a component that generates heat in the working process of the wireless charger 100, and may be attached to the circuit board 21. For example, the electronic element 22 may be a chip or a circuit.

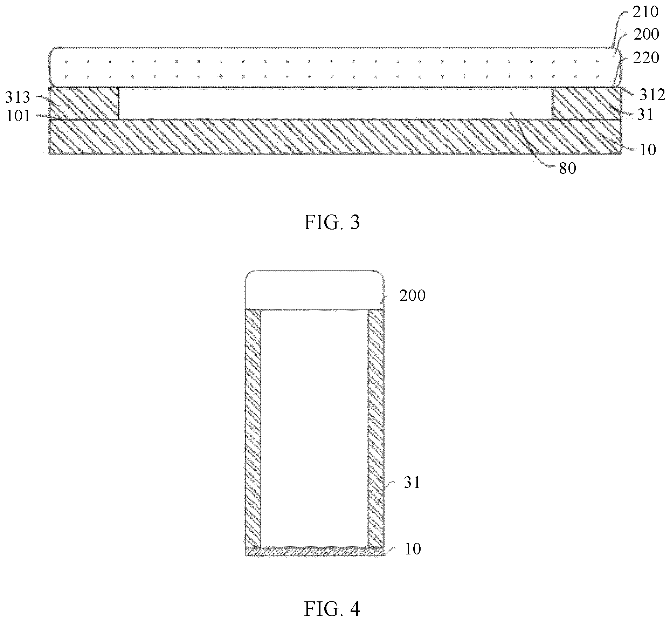

Refer to FIG. 2 and FIG. 3. The heat conduction structure 30 is a heat conduction component of the wireless charger 100, and includes the contact part 31 and a connection part 32 that are connected to each other. At least a part of the contact part 31 is exposed to the outer surface 101 of the housing 10, and is configured to abut on the to-be-charged device 200. The connection part 32 is located inside the housing 10, and the connection part 32 is in contact with the heat dissipation air channel 17 and the cooling air channel 18. The contact part 31, the outer surface 101 of the housing 10, and the to-be-charged device 200 cooperate to form a ventilation channel 80 that communicates with the heat dissipation air channel 17.

"At least a part of the contact part 31 is exposed to the outer surface 101 of the housing 10" may include the following: All of the contact part 31 is exposed to the outer surface 101 of the housing 10; a part of the contact part 31 is exposed to the outer surface 101 of the housing 10, and a part is disposed in the housing 10; or a surface of the contact part 31 that is in contact with the to-be-charged device 200 is coplanar with the outer surface 101 of the housing 10.

For example, the contact part 31 and the connection part 32 are an integral structure. In other words, the entire heat conduction structure 30 may be an integral structure. The heat conduction structure 30 produced by using an integral structure has fewer processing steps. This can effectively reduce production costs and time costs, and improve processing production efficiency of the wireless charger 100. In addition, the heat conduction structure 30 may further be flexible, so that the heat conduction structure 30 is bendable. In other words, the contact part 31 can be bent relative to the connection part 32 (which may be understood as that the connection part 32 can be bent relative to the contact part 31), so that a form of the contact part 31 can change with an elevation angle of the housing 10, to flexibly adapt to an application requirement existing when the elevation angle of the housing 10 is changeable. For example, the heat conduction structure 30 may be a heat pipe or a vapor chamber (Vapor Chambers, VC). However, it should be understood that a heat conduction material that has high heat conduction performance and that can effectively conduct the heat of the to-be-charged device 200 may be applied to the wireless charger 100 provided in this embodiment of this application. This is not strictly limited.

It may be understood that the heat conduction structure 30 extends from the outer surface 101 of the housing 10 to the inside of the housing 10. A part of the heat conduction structure 30 that is exposed to the outside of the housing 10 is in contact with the to-be-charged device 200, and a part of the heat conduction structure 30 that is located in the housing 10 is in contact with the heat dissipation air channel 17. Therefore, the heat of the to-be-charged device 200 can be transferred to the inside of the wireless charger 100 through heat conduction by the heat conduction structure 30, to dissipate heat for the to-be-charged device 200. In other words, at least a part of the contact part 31 is used as a part of the heat conduction structure 30 that is located outside the housing 10, and can be directly in contact with the to-be-charged device 200 to conduct the heat of the to-be-charged device 200 to the heat conduction structure 30. The connection part 32 is used a part of the heat conduction structure 30 that is located in the housing 10, and can be directly in contact with the heat dissipation air channel 17 to further conduct the heat of the to-be-charged device 200 to the inside of the wireless charger 100, so as to fully use the heat conduction capability of the wireless charger 100.

In other words, the heat of the to-be-charged device 200 may be transferred to the inside of the wireless charger 100 by using the heat conduction structure 30, and is dissipated through the heat dissipation air channel 17 of the wireless charger 100, so that the wireless charger 100 can dissipate heat for the to-be-charged device 200. In case of the disposition, the heat conduction capability of the wireless charger 100 can be improved, and a possibility that a temperature of the to-be-charged device 200 rises within short time is minimized based on the heat conduction capability and a heat dissipation function of the to-be-charged device 200, so that the to-be-charged device 200 has good thermal equilibrium, and the wireless charger 100 can maintain good working performance. In other words, the wireless charger 100 can provide good heat dissipation performance for the to-be-charged device 200, so that thermal equilibrium of the to-be-charged device does not easily affect the charging power of the wireless charger 100. Therefore, when the wireless charger 100 has same charging power, the temperature of the to-be-charged device 200 can be greatly lowered. In other words, when the wireless charger 100 dissipates heat for heating points under a same condition, namely, when the wireless charger 100 achieves a same heat dissipation objective, the heat dissipation capability of the wireless charger 100 can be greatly improved. This helps better improve the charging power of the wireless charger 100 and user experience.

In the working process of the wireless charger 100, the electronic element 22 used as a heating element generates a large amount of heat, and therefore forms a heating point at a corresponding position inside the wireless charger 100. A temperature of the heating point is high. If the heat generated by the heating point is not effectively dissipated in a timely manner, working performance of the wireless charger 100 is directly affected. For example, if local overheating occurs, the wireless charger 100 fails. In addition, a temperature of the housing 10 at a position corresponding to the heating point is also correspondingly high. Consequently, local overheating occurs in the housing 10, and user experience is severely affected. In other words, thermal equilibrium of the wireless charger 100 also directly affects the working performance of the wireless charger 100. Therefore, the circuit board component 20 is disposed in the heat dissipation air channel 17, so that the wireless charger 100 can dissipate heat for the wireless charger 100. In other words, the wireless charger 100 can dissipate heat for both the wireless charger 100 and the to-be-charged device 200, so that the heat of the wireless charger 100 and the to-be-charged device 200 can be effectively dissipated through the heat dissipation air channel 17, and the entire wireless charger 100 has a good heat conduction temperature difference and good heat transfer efficiency. This effectively improves heat conduction performance of the wireless charger 100.

In addition, the contact part 31, the outer surface 101 of the housing 10, and the to-be-charged device 200 can cooperate to form the ventilation channel 80 that communicates with the heat dissipation air channel 17. Therefore, air in the external environment can be conveniently and quickly guided into the ventilation channel 80. This has a good guiding function. In addition, an area in which the housing 10 of the wireless charger 100 and a housing of the to-be-charged device 200 are in contact with air can be greatly improved without excessively occupying space in the housing 10 of the wireless charger 100. This further plays a role of dissipating heat for the wireless charger 100 and the to-be-charged device 200.

The heat dissipation structure 40 is a main heat dissipation structure of the wireless charger 100, is accommodated in the heat dissipation air channel 17 inside the housing 10 and is connected to the contact part 31 of the heat conduction structure 30, and is further adjacent to the circuit board component 20. The heat conduction structure 30 conducts heat, so that the heat dissipation structure 40 dissipates heat for the circuit board component 20 and the to-be-charged device 200. In other words, due to a good heat dissipation function of the heat dissipation structure 40, heat conducted to the inside of the wireless charger 100 can be effectively dissipated in a timely manner, to perform temperature balance for the wireless charger 100, and improve heat dissipation reliability existing when the wireless charger 100 works normally.

It may be understood that, because the heat dissipation structure 40 is connected to the heat conduction structure 30, heat of the heat conduction structure 30 may be dissipated by using the heat dissipation structure 40, so that the heat dissipation structure 40 can dissipate heat for both the to-be-charged device 200 and the wireless charger 100. This diversifies use performance of the heat dissipation structure 40, so that the heat dissipation capability of the wireless charger 100 can be greatly improved. This helps better improve the charging power of the wireless charger 100 and user experience.

Refer to FIG. 2, FIG. 4, and FIG. 5. The coil component 50 may be understood as the foregoing transmit coil, may be electrically connected to the circuit board component 20, can send an electromagnetic signal to the outside under an action of electric power, and may be coupled to a receive coil disposed in the to-be-charged device 200. The coil component 50 may include a coil 51 and a magnetic sheet 52 that are disposed in a stack manner. The coil 51 may be an electromagnetic induction coil 51. The electromagnetic induction coil 51 generates a magnetic field during power-on, and outputs electric energy to the to-be-charged device 200 through electromagnetic induction. The magnetic sheet 52 can enhance magnetic field strength of the coil 51, increase energy transfer efficiency, and increase a charging speed of the to-be-charged device 200.

It should be understood that there may be one or more coil components 50. When there is one coil component 50, the coil component 50 may charge only one to-be-charged device 200, and corresponds to the to-be-charged device 200 in a one-to-one relationship. When there are a plurality of coil components 50, the coil components 50 may charge only one to-be-charged device 200, namely, the plurality of coil components 50 correspond to only one to-be-charged device 200 in a many-to-one relationship. Alternatively, the plurality of coil components 50 may simultaneously charge a plurality of to-be-charged devices 200, namely, the plurality of coil components 50 correspond to a plurality of to-be-charged devices 200 in a many-to-many relationship. A manner of arranging the plurality of coil components 50 may be as follows: The plurality of coil components 50 are disposed at intervals, or the plurality of coil components 50 are overlapped. "The plurality of coil components 50 are overlapped" may be understood as that there is a common overlapping area between two adjacent coil components 50, that is, at least a part of an orthogonal projection of one coil component 50 in the housing 10 falls within a range of an orthogonal projection of the other coil component 50 in the housing 10.

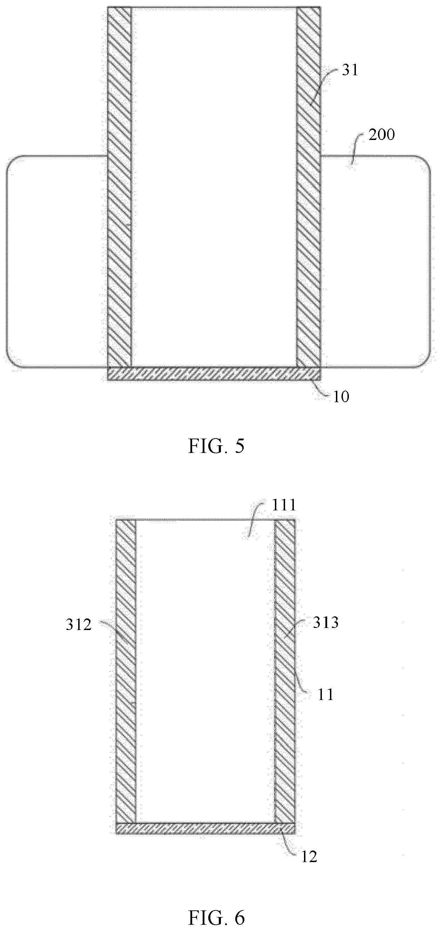

For example, there may be two coil components 50, so that the wireless charger 100 has a dual coil 51 with a larger induction range. In this way, the wireless charger 100 can be applied to a vertical placement scenario of the to-be-charged device 200 shown in FIG. 4, and can also be applied to a horizontal placement scenario of the to-be-charged device 200 shown in FIG. 5, to adapt to and support application requirements of the to-be-charged device 200 in a plurality of scenarios, effectively increase a charging speed of the wireless charger 100, and improve charging efficiency of the wireless charger 100.

In a possible implementation, the coil component 50 may further include a support 53 disposed on a side of the magnetic sheet 52 that faces away from the coil 51. The support 53 may be of a metal material, and can be used to perform temperature balance for the coil 51 and the magnetic sheet 52. When there are a plurality of coils 51, the plurality of coils 51 may share one support 53, so that the support 53 performs temperature balance for the plurality of coils 51.

The first fan 60 is a power source that enables air in the wireless charger 100 to flow, is disposed in the heat dissipation air channel 17 of the housing 10 and corresponds to the first air inlet 13, and may be electrically connected to the circuit board component 20. Therefore, air that enters the wireless charger 100 may be driven by the first fan 60 to flow in the heat dissipation air channel 17. This helps improve air flow and heat dissipation performance of the wireless charger 100. For example, the first fan 60 may be but is not limited to a centrifugal fan, an axial fan, and a piezoelectric fan.

The second fan 70 is a power source that enables air in the wireless charger 100 to flow, is disposed in the cooling air channel 18 of the housing 10 and corresponds to the second air inlet 14, and may be electrically connected to the circuit board component 20. Therefore, air that enters the wireless charger 100 may be driven by the second fan 70 to flow in the cooling air channel 18. This helps improve air flow and heat dissipation performance of the wireless charger 100. For example, the second fan 70 may be but is not limited to a centrifugal fan, an axial fan, and a piezoelectric fan.

The following describes a structure possibility of the wireless charger 100, namely, structures and connection positions of the components and a connection relationship among the components. An example in which the wireless charger 100 is a vertical charger is mainly used for description. It should be understood that, when the wireless charger 100 is a vertical charger, the wireless charger 100 may be a charger with a fixed elevation angle or a charger with an adjustable elevation angle, and may support vertical screen charging or horizontal screen charging. This is not strictly limited in this embodiment of this application.

Refer to FIG. 1 and FIG. 2. The housing 10 includes a body 11 and a base 12, and a bottom of the body 11 is connected to the base 12. The body 11 may be understood as a housing structure that mainly supports the to-be-charged device 200. The base 12 may be understood as a housing structure that can be placed on an object bearing platform (such as a desk or a tea table) to provide good contact stability for the wireless charger 100.

The body 11 and the base 12 may be disposed at an angle, so that the entire housing 10 presents a vertical structure, to provide good user experience for the user. For example, the body 11 is fastened relative to the base 12, namely, an included angle between the body 11 and the base 12 is fixed. An angle range of the included angle between the body 11 and the base 12 may be an angle range of 0° to 90°. Alternatively, the body 11 is capable of rotating relative to the base 12, namely, the body 11 is rotatably connected to the base 12, and an included angle between the body 11 and the base 12 is adjustable. An angle range of the included angle between the body 11 and the base 12 may be an angle range of 0° to 90°. For example, the included angle between the body 11 and the base 12 may be 60°. Therefore, an elevation angle of the wireless charger 100 may be autonomously adjusted based on an actual case. This helps more actively adapt to application requirements in a plurality of scenarios, so that the user can use the to-be-charged device 200 while charging the to-be-charged device 200. This has operation comfort and strong convenience.

The body 11 and the base 12 may be an integral structure, namely, the entire housing 10 may be an integral structure. The housing 10 produced by using an integral structure has fewer processing steps. This can effectively reduce production costs and time costs, and improve processing production efficiency of the wireless charger 100. For example, the body 11 and the base 12 may be connected to each other in a manner of welding, gluing, crimping, fastening by using a screw, or the like, to form the integral structure. Alternatively, the integral structure may be integrally formed. In other words, the body 11 is connected to the base 12 to form the integral structure.

The body 11 includes a heat dissipation surface 111, and the heat dissipation surface 111 may be understood as a surface of the body 11 that faces the to-be-charged device 200. When the to-be-charged device 200 is placed on the wireless charger 100, the front surface 220 of the to-be-charged device 200 may directly face the heat dissipation surface 111. In other words, the heat dissipation surface 111 is the outer surface 101 of the housing 10, where the outer surface 101, the contact part 31 of the heat conduction structure 30, and the to-be-charged device 200 canjointly form the ventilation channel 80.

The first air inlet 13 may be disposed on the heat dissipation surface 111, so that the first air inlet 13 can directly communicate with the ventilation channel 80, and air that enters through the ventilation channel 80 can enter the body 11. There may be one or more first air inlets 13. The first air inlet 13 may be disposed in a center region of the heat dissipation surface 111, or may be disposed in an edge region of the heat dissipation surface 111. When there are a plurality of first air inlets 13, the plurality of first air inlets 13 may be centrally arranged in a region of the heat dissipation surface 111, or the plurality of first air inlets 13 may be dispersedly arranged in various regions of the heat dissipation surface 111.

In this embodiment of this application, the contact part 31 is connected to the heat dissipation surface 111, and at least a part of the contact part 31 is exposed to the heat dissipation surface 111, so that the contact part 31, the heat dissipation surface 111, and the to-be-charged device 200 cooperate to form the ventilation channel 80.

In a possible implementation, the contact part 31 includes a heat conduction surface 311 that is in contact with the to-be-charged device 200, and the heat conduction surface 311 is coplanar with the heat dissipation surface 111 to jointly form the outer surface 101 of the housing 10. A heat dissipation groove is further disposed on the outer surface of the housing 10 that is jointly formed by the heat dissipation surface 111 and the heat conduction surface 311, and an opening of the heat dissipation groove extends from the heat dissipation surface 111 to the heat conduction surface 311. The first air inlet 13 may be disposed on a groove wall of the heat dissipation groove.

In other words, in this implementation, a part of the contact part 31 other than the heat conduction surface 311 of the contact part 31 is built in the housing 10, so that the heat conduction surface 311 is coplanar with the heat dissipation surface 111. Therefore, the heat conduction surface 311, the heat dissipation surface 111, the heat dissipation groove, and the to-be-charged device 200 jointly form the ventilation channel 80.

In another possible implementation, the contact part 31 includes a heat conduction surface 311 that is in contact with the to-be-charged device 200, and there is a height difference between the heat conduction surface 311 and the outer surface 101 of the housing 10, namely, the heat dissipation surface 111. "There is a height difference" may be understood as follows: The contact part 31 is totally protruded from the heat dissipation surface 111, or a part of the contact part 31 is built in the housing 10, and a part is exposed to the heat dissipation surface 111.

Therefore, the height difference between the heat conduction surface 311 and the heat dissipation surface 111 can be flexibly adjusted based on an actual requirement, so that the formed ventilation channel 80 can guide external air to the inside of the wireless charger 100 to a maximum degree. This effectively improves the heat dissipation capability of the wireless charger 100.

Refer to FIG. 2 and FIG. 6. For example, the contact part 31 includes a first side part 312 and a second side part 313. The first side part 312 and the second side part 313 are protruded from the heat dissipation surface 111 and are respectively located on two sides of the heat dissipation surface 111. A gap is disposed between the first side part 312 and the second side part 313. Both the first side part 312 and the second side part 313 extend from a top of the body 11 to the bottom of the body 11. For example, the first side part 312 and the second side part 313 may be in a long strip shape, and are respectively located on two edges of the heat dissipation surface 111.

Therefore, the heat of the to-be-charged device 200 can be conducted without excessively occupying a surface area of the housing 10. In addition, the to-be-charged device 200 can also be in no direct contact with the wireless charger 100 by using the gap of the contact part 31, so that the ventilation channel 80 can be formed between the to-be-charged device 200 and the wireless charger 100 to expand a heat dissipation area 111. This helps further improve the heat conduction capability and heat dissipation efficiency of the wireless charger 100.

Refer to FIG. 1 and FIG. 2. First accommodation space 112 is disposed in the body 11, the first accommodation space 112 communicates with the first air inlet 13, and the first fan 60 and the coil component 50 may be accommodated inside the first accommodation space 112.

Specifically, the first fan 60 is located in the first accommodation space 112 and corresponds to the first air inlet 13. "The first fan 60 corresponds to the first air inlet 13" may be understood as follows: Wind that enters the first accommodation space 112 through the first air inlet 13 can blow to the first fan 60, and air that enters the heat dissipation air channel 17 through the first air inlet 13 can be driven by the first fan 60 to flow out through the first air outlet 15 to dissipate heat for the front surface 220 of the to-be-charged device 200. The front surface 220 of the to-be-charged device 200 is a surface that faces the heat dissipation surface 111.

A gap is disposed between the coil component 50 and the first fan 60 in the first accommodation space 112. A position of the coil component 50 may be fixed to provide a transmit signal only in a limited region. Alternatively, a position of the coil component 50 may change with a placement scenario of the to-be-charged device 200, namely, the position of the coil component 50 may be moved. For example, when the to-be-charged device 200 is vertically placed, the coil component 50 may be adjusted to a corresponding position by sensing a position of a receive coil existing when the to-be-charged device 200 is vertically placed. When the to-be-charged device 200 is horizontally placed, the coil component 50 may be moved to a corresponding position by sensing a position of a receive coil existing when the to-be-charged device 200 is horizontally placed. In this way, the coil component 50 can always maintain coupled to the receive coil due to movable performance. This has high wireless charging accuracy and efficiency, and helps adapt to application scenario requirements of the wireless charger 100 in a plurality of scenarios.

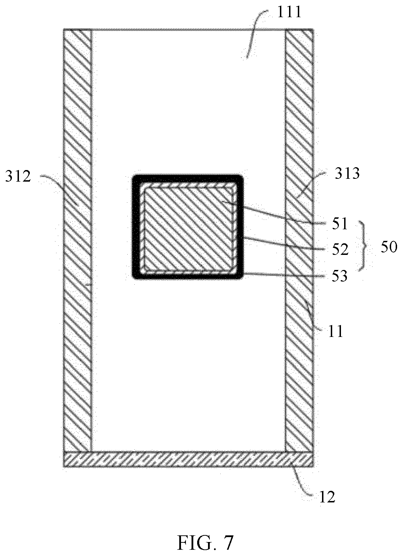

Refer to FIG. 7. For example, an orthogonal projection of the coil component 50 on the heat dissipation surface 111 falls within a range of an orthogonal projection of a gap region between the first side part 312 and the second side part 313 on the heat dissipation surface 111. Therefore, the first side part 312 and the second side part 313 can be disposed without preventing the coil component 50 from transmitting a power signal, so that an induction range of the coil component 50 is larger, and the charging power of the wireless charger 100 can be optimized.

Refer to FIG. 1, FIG. 2, and FIG. 3. The base 12 includes a bearing surface 121, a bottom surface 122, and a side surface 123 connected to the bottom surface 122. The bearing surface 121 is connected to the heat dissipation surface 111. When the to-be-charged device 200 is placed on the wireless charger 100, a bottom of the to-be-charged device 200 is in contact with the bearing surface 121. The bottom surface 122 may be understood as a surface that directly faces the object bearing platform when the wireless charger 100 is placed on the object bearing platform. The side surface 123 is connected to the bottom surface 122 and is away from the body 11. Second accommodation space 124 is disposed in the base 12, and the second accommodation space 124 communicates with the first accommodation space 112, the second air inlet 14, the first air outlet 15, and the second air outlet 16.

The first air outlet 15 may be disposed on the side surface 123, so that the first air outlet 15 can directly communicate with the heat dissipation air channel 17, and air carrying heat in the heat dissipation air channel 17 can flow out of the wireless charger 100. There may be one or more first air outlets 15. The first air outlet 15 may be disposed in a center region of the side surface 123, or may be disposed in an edge region of the side surface 123. When there are a plurality of first air outlets 15, the plurality of first air outlets 15 may be centrally arranged in a region of the side surface 123, or the plurality of first air outlets 15 may be dispersedly arranged in various regions of the side surface 123.

It may be understood that, because the heat dissipation air channel 17 communicates with the first air inlet 13 and the first air outlet 15, the heat dissipation air channel 17 can extend from the first accommodation space 112 to the second accommodation space 124. In other words, at least a part of the first accommodation space 112 and at least a part of the second accommodation space 124 form the heat dissipation air channel 17, and the heat dissipation air channel 17 extends from the body 11 to the base 12, so that the heat dissipation air channel 17 is evenly distributed at each part of the housing 10. This helps improve temperature balance performance of the housing 10, so that the housing 10 has a good heat conduction temperature difference and good heat dissipation efficiency, to further improve the heat dissipation capability of the wireless charger 100.

The second air inlet 14 may be disposed on the bottom surface 122, so that the second air inlet 14 can directly communicate with the cooling air channel 18, and air carrying heat in the cooling air channel 18 can flow out of the wireless charger 100. There may be one or more second air inlets 14. The second air inlet 14 may be disposed in a center region of the bottom surface 122, or may be disposed in an edge region of the bottom surface 122. When there are a plurality of second air inlets 14, the plurality of second air inlets 14 may be centrally arranged in a region of the bottom surface 122, or the plurality of second air inlets 14 may be dispersedly arranged in various regions of the bottom surface 122.

In a possible implementation, the wireless charger 100 further includes an anti-slip structure, and the anti-slip structure is disposed on the bottom surface 122 of the base 12, so that the wireless charger 100 has good placement stability. For example, the anti-slip structure may be an anti-slip pad.

The second air outlet 16 may be disposed on the bearing surface 121, so that the second air outlet 16 can directly communicate with the cooling air channel 18, and air carrying heat in the cooling air channel 18 can flow out of the wireless charger 100. There may be one or more second air outlets 16. The second air outlet 16 may be disposed in an edge region of the bearing surface 121. The edge region of the bearing surface 121 may be understood as a position that is not blocked by the to-be-charged device 200 and at which heat dissipation can be performed for the front surface 210 of the to-be-charged device 200. When there are a plurality of second air outlets 16, the plurality of second air outlets 16 may be centrally arranged in a region of the bearing surface 121, or the plurality of second air outlets 16 may be dispersedly arranged in various regions of the bearing surface 121.

It may be understood that, because the cooling air channel 18 communicates with the second air inlet 14 and the second air outlet 16, the cooling air channel 18 is located in the second accommodation space 124. In other words, at least a part of the second accommodation space 124 forms the cooling air channel 18, and the cooling air channel 18 extends from one end of the base 12 to the other end of the base 12, so that the cooling air channel 18 is evenly distributed inside the base 12. This helps air that is cooled in the cooling air channel 18 stably and efficiently blow to the to-be-charged device 200, to further lower the temperature of the to-be-charged device 200, and better improve user experience.

In a possible implementation, the wireless charger 100 further includes a limiting structure, the limiting structure is disposed on the bearing surface 121 of the base 12, and the body 11 cooperates with the base 12 to support and limit the to-be-charged device 200. For example, the limiting structure may be a protrusion disposed on the bearing surface 121.

Based on the foregoing descriptions, it should be understood that both the heat dissipation air channel 17 and the cooling air channel 18 are integrated into the wireless charger 100, so that the heat dissipation air channel 17 can dissipate heat for the front surface 220 of the to-be-charged device 200, and the cooling air channel 18 can cool the front surface 210 of the to-be-charged device 200. Therefore, heat dissipation requirements of both the to-be-charged device 200 and the wireless charger 100 are considered, and heat dissipation efficiency is further improved. Therefore, this helps improve the charging power of the wireless charger 100.

Refer to FIG. 1, FIG. 2, and FIG. 3. The second fan 70, the connection part 32, the heat dissipation structure 40, and the circuit board component 20 may be accommodated inside the second accommodation space 124.

Specifically, the second fan 70 is located in the second accommodation space 124 and corresponds to the second air inlet 14. "The second fan 70 corresponds to the second air inlet 14" may be understood as follows: Wind that enters the second accommodation space 124 through the second air inlet 14 can blow to the second fan 70, and air that enters the cooling air channel 18 through the second air inlet 14 can be driven by the second fan 70 to be cooled and then flow out through the second air outlet 16 to dissipate heat for the front surface 210 of the to-be-charged device 200. The front surface 210 of the to-be-charged device 200 is a surface that faces away from the heat dissipation surface 111.

The bearing surface 121 may be provided with a perforation 125. The perforation 125 is disposed on a side near the heat dissipation surface 111, and the perforation 125 and the second air outlet 16 are respectively located on two sides of the bearing surface 121. The contact part 31 extends from the top of the body 11 to the bottom of the body 11, the contact part 31 passes through the perforation 125, the contact part 31 is connected to the connection part 32 located in the second accommodation space 124, and the contact part 31 and the connection part 32 are disposed at an angle.

In other words, a part of the contact part 31 may be disposed outside the housing 10, and a part may be disposed inside the housing 10. Therefore, this can conveniently and quickly connect the to-be-charged device 200 located outside the housing 10 and the heat dissipation structure 40 located inside the housing 10, so that the heat of the to-be-charged device 200 can be transferred to the wireless charger 100 and is dissipated by using the heat dissipation structure 40. The contact part 31 and the connection part 32 are disposed at an angle. This can fully adapt to an appearance form of the wireless charger 100, and well adapt to narrow space arrangement inside the housing 10 of the wireless charger 100, so that application requirements in a plurality of space configurations are met, and flexibility is strong. This helps adapt to a miniaturization development trend of the wireless charger 100.

It should be understood that, when the elevation angle of the wireless charger 100 is adjustable, the body 11 is capable of rotating relative to the base 12 and driving the contact part 31 to be bent relative to the connection part 32. An included angle between the contact part 31 and the connection part 32 can adaptively change with the included angle between the body 11 and the base 12. Therefore, in a process of adjusting the elevation angle of the wireless charger 100, the heat conduction structure 30 can always be stably connected between the to-be-charged device 200 and the heat dissipation structure 40, and reliability is good.

The heat dissipation structure 40 includes a semiconductor cooling member 41, a first heat sink 42, and a second heat sink 42. The semiconductor cooling member 41 includes a cold surface 412 and a hot surface 411 that are disposed oppositely each other. The first heat sink 42 is disposed on the hot surface 411 and is located in the heat dissipation air channel 17. The second heat sink 42 is located between the cold surface 412 and the contact part 31.

It may be understood that, the heat conduction structure 30 conducts the heat generated by the to-be-charged device 200 to the cold surface 412 of the semiconductor cooling member 41, the cold surface 412 can absorb heat to lower a temperature, and a heat dissipation fin of the second heat sink 42 disposed on the cold surface 412 can continuously perform cooling. In this way, wind that enters the cooling air channel 18 through the second air outlet 16 can be cooled after a temperature of the wind is further lowered under an action of the heat dissipation fin of the second heat sink 42, so that the cooled cold air can flow out through the second air outlet 16 to blow to the to-be-charged device 200. The heat absorbed by the cold surface 412 can be released by using the hot surface 411, and the heat is effectively dissipated under an action of a heat dissipation fin of the first heat sink 42, so that hot air can flow in the heat dissipation air channel 17 and is brought out of the wireless charger 100, to dissipate heat for that wireless charger 100 through heat exchange.

In a possible implementation, the wireless charger 100 further includes a fin, and the fin is located on an inner wall of the first accommodation space 112 and/or an inner wall of the second accommodation space 124. For example, the fin may be disposed on an inner wall of the heat dissipation air channel 17.

Therefore, this can effectively increase the heat dissipation area, enhance heat dissipation, and improve heat dissipation efficiency of the wireless charger 100. It should be noted that the fin and the inner wall may be an integral structure. The fin may have different fin types, for example, a pin-shaped fin, a fan-shaped fin, and a ring-shaped fin. This is not strictly limited in this embodiment of this application.

The description about the embodiments of this application is merely provided to help understand the method and core ideas of this application.

## Claims

1. A wireless charger (100), wherein the wireless charger comprises:
a housing (10), wherein the housing has a first air inlet (13), a first air outlet (15), a second air inlet (14) and a second air outlet (16), a heat dissipation air channel (17) that communicates with the first air inlet (13) and the first air outlet (15) and that is located inside the housing being formed between the first air inlet (13) and the first air outlet (15), and a cooling air channel (18) that is configured to communicate with the second air inlet (14) and the second air outlet (16) and that is located inside the housing (10) is formed
between the second air inlet (14) and the second air outlet (16);
a circuit board component (20), wherein the circuit board component (20) is located in the heat dissipation air channel (17);
a heat conduction structure (30), wherein the heat conduction structure (30) comprises a contact part (31) and a connection part (32) that are connected to each other, at least a part of the contact part (31) is exposed to an outer surface of the housing (101), the contact part (31) is configured to be in contact with a to-be-charged device (200), the connection part (32) is located inside the housing (10) and is in contact with the heat dissipation air channel (17), the contact part (31), the outer surface of the housing (101), and the to-be-charged device (200) are configured to cooperate to form a ventilation channel (80), and the ventilation channel (80) is configured to communicate with the heat dissipation air channel (17);
a heat dissipation structure (40), wherein the heat dissipation structure (40) is located in the heat dissipation air channel (17) and is connected to the connection part (32), the heat dissipation structure (30) is adjacent to the circuit board component (20), and the heat conduction structure (30) is configured to conduct heat; and
wherein the heat dissipation air channel (17) and the cooling air channel (18) are respectively located on two opposite sides of the contact part (31) of the heat conduction structure (30).

2. The wireless charger (100) according to claim 1, wherein the contact part (31) comprises a heat conduction surface (311) that is in contact with the to-be-charged device (200), and there is a height difference between the heat conduction surface (311) and the outer surface of the housing (101).

3. The wireless charger (100) according to claim 1, wherein the housing (10) comprises a heat dissipation surface (111) that faces the to-be-charged device (200), the contact part (31) comprises a first side part (312) and a second side part (313), the first side part (312) and the second side part (313) are protruded from the heat dissipation surface (111) and are respectively located on two sides of the heat dissipation surface (111), and a gap is disposed between the first side part (312) and the second side part (313).

4. The wireless charger (100) according to any one of claims 1 to 3, wherein the contact part (31) and the connection part (32) are an integral structure, and the integral structure is flexible.

5. The wireless charger (100) according to any one of claims 1 to 3, the heat dissipation structure (40) comprises a semiconductor cooling member and a first heat sink, the semiconductor cooling member comprises a cold surface (412), and the first heat sink is located between the cold surface (412) and the contact part (31).

6. The wireless charger (100) according to claim 5, wherein the heat dissipation structure (40) further comprises a second heat sink, the semiconductor cooling member further comprises a hot surface (411) disposed oppositely to the cold surface (412), and the second heat sink is located in the heat dissipation air channel (17) and is connected to the hot surface (411).

7. The wireless charger (100) according to any one of claims 1 to 6, wherein the housing (10) comprises a body (11) and a base (12), a bottom of the body (11) is connected to the base (12), a surface of the body (11) that faces the to-be-charged device (200) is the heat dissipation surface (111), the base (12) comprises a bearing surface (121) connected to the heat dissipation surface (111), and the bearing surface (121) is provided with a perforation (125); and
the contact part (31) extends from a top of the body to the bottom of the body, the contact part (31) passes through the perforation (125), the contact part (31) is connected to the connection part (32) located inside the base (12), and the contact part (31) and the connection part (32) are disposed at an angle.

8. The wireless charger (100) according to claim 7, wherein the body is capable of rotating relative to the base (12) and driving the contact part (31) to be bent relative to the connection part (32).

9. The wireless charger (100) according to claim 7, wherein first accommodation space (112) communicating with the first air inlet (13) is disposed in the body (11), second accommodation space (124) communicating with the first accommodation space (112) is disposed in the base (12), and the connection part (32), the circuit board component (20), the heat dissipation structure (40), and the heat conduction structure (30) are all located in the second accommodation space (124);
the first air inlet (13) is located on the heat dissipation surface (111), the heat dissipation air channel (17) extends from the first accommodation space (112) to the second accommodation space (124), and the first air outlet (15) is located on a side surface of the base (12); and
the wireless charger (100) further comprises a first fan (60), the first fan (60) is located in the first accommodation space (112) and corresponds to the first air inlet (13), and air that enters the heat dissipation air channel (17) through the first air inlet (13) is driven by the first fan (60) to flow out through the first air outlet (15) to dissipate heat for a back surface of the to-be-charged device (200), wherein the back surface of the to-be-charged device (200) is a surface that faces the heat dissipation surface (111).

10. The wireless charger (100) according to claim 9, wherein the second air inlet (14) is located on a bottom surface of the base (12), the cooling air channel (18) is formed in the second accommodation space (124), and the second air outlet (16) is located on the bearing surface of the base (12); and
the wireless charger (100) further comprises a second fan (70), the second fan (70) is located in the second accommodation space (124) and corresponds to the second air inlet (14), and the second fan and the first heat sink cooperate, so that air that enters the second accommodation space through the second air inlet (14) is cooled and then flows out through the second air outlet (16) to dissipate heat for a front surface of the to-be-charged device (200), wherein the front surface of the to-be-charged device (200) is a surface that faces away from the heat dissipation surface (111).

11. The wireless charger (100) according to claim 9, wherein the heat dissipation structure (40) further comprises a coil component (50), the coil component (50) is located inside the first accommodation space (112), and an orthogonal projection of the coil component (50) on the heat dissipation surface (111) falls within a range of an orthogonal projection of a gap region between the first side part and the second side part on the heat dissipation surface (111).

12. The wireless charger (100) according to claim 9, wherein the wireless charger (100) further comprises a fin, and the fin is located on an inner wall of the first accommodation space and/or an inner wall of the second accommodation space.

## Patentansprüche

1. Drahtloses Ladegerät (100), wobei das drahtlose Ladegerät Folgendes umfasst:
ein Gehäuse (10), wobei das Gehäuse einen ersten Lufteinlass (13), einen ersten Luftauslass (15), einen zweiten Lufteinlass (14) und einen zweiten Luftauslass (16), einen Wärmeabführluftkanal (17), der mit dem ersten Lufteinlass (13) und dem ersten Luftauslass (15) kommuniziert und der sich innerhalb des Gehäuses befindet und zwischen dem ersten Lufteinlass (13) und dem ersten Luftauslass (15) gebildet ist, und einen Kühlluftkanal (18), der ausgestaltet ist, um mit dem zweiten Lufteinlass (14) und dem zweiten Luftauslass (16) zu kommunizieren und sich innerhalb des Gehäuses (10) befindet und zwischen dem zweiten Lufteinlass (14) und dem zweiten Luftauslass (16) gebildet ist, aufweist;
eine Schaltplatinenkomponente (20), wobei die Schaltplatinenkomponente (20) sich in dem Wärmeabführluftkanal (17) befindet;
eine Wärmeleitstruktur (30), wobei die Wärmeleitstruktur (30) ein Kontaktteil (31) und ein Verbindungsteil (32) umfasst, die miteinander verbunden sind, wobei mindestens ein Teil des Kontaktteils (31) einer Außenoberfläche des Gehäuses (101) ausgesetzt ist, wobei das Kontaktteil (31) ausgestaltet ist, um in Kontakt mit einer zu ladenden Vorrichtung (200) zu sein, wobei sich das Verbindungsteil (32) innerhalb des Gehäuses (10) befindet und in Kontakt mit dem Wärmeabführluftkanal (17) ist, wobei das Kontaktteil (31), die Außenoberfläche des Gehäuses (101) und die zu ladende Vorrichtung (200) ausgestaltet sind, um zusammenzuwirken, um einen Lüftungskanal (80) zu bilden, und wobei der Lüftungskanal (80) ausgestaltet ist, um mit dem Wärmeabführluftkanal (17) zu kommunizieren;
eine Wärmeabführstruktur (40), wobei die Wärmeabführstruktur (40) sich in dem Wärmeabführluftkanal (17) befindet und mit dem Verbindungsteil (32) verbunden ist, wobei die Wärmeabführstruktur (30) benachbart zu der Schaltplatinenkomponente (20) ist, und die Wärmeleitstruktur (30) ausgestaltet ist, um Wärme zu leiten; und
wobei der Wärmeabführluftkanal (17) und der Kühlluftkanal (18) sich jeweils auf zwei gegenüber liegenden Seiten des Kontaktteils (31) der Wärmeleitstruktur (30) befinden.

2. Drahtloses Ladegerät (100) nach Anspruch 1, wobei das Kontaktteil (31) eine Wärmeleitoberfläche (311) umfasst, die in Kontakt mit der zu ladenden Vorrichtung (200) ist, und wobei eine Höhendifferenz zwischen der Wärmeleitoberfläche (311) und der Au-βenoberfläche des Gehäuses (101) vorliegt.

3. Drahtloses Ladegerät (100) nach Anspruch 1, wobei das Gehäuse (10) eine Wärmeabführoberfläche (111) umfasst, die zu der zu ladenden Vorrichtung (200) weist, wobei das Kontaktteil (31) ein erstes Seitenteil (312) und ein zweites Seitenteil (313) umfasst, wobei das erste Seitenteil (312) und das zweite Seitenteil (313) von der Wärmeabführoberfläche (111) vorspringen und sich jeweils auf zwei Seiten der Wärmeabführoberfläche (111) befinden, und wobei ein Spalt zwischen dem ersten Seitenteil (312) und dem zweiten Seitenteil (313) angeordnet ist.

4. Drahtloses Ladegerät (100) nach einem der Ansprüche 1 bis 3, wobei das Kontaktteil (31) und das Verbindungsteil (32) eine integrale Struktur sind und die integrale Struktur flexibel ist.

5. Drahtloses Ladegerät (100) nach einem der Ansprüche 1 bis 3, wobei die Wärmeabführstruktur (40) ein Halbleiterkühlelement und eine erste Wärmesenke umfasst, wobei das Halbleiterkühlelement eine kalte Oberfläche (412) umfasst und die erste Wärmesenke sich zwischen der kalten Oberfläche (412) und dem Kontaktteil (31) befindet.

6. Drahtloses Ladegerät (100) nach Anspruch 5, wobei die Wärmeabführstruktur (40) des Weiteren eine zweite Wärmesenke umfasst, das Halbleiterkühlelement des Weiteren eine heiße Oberfläche (411) umfasst, die gegenüber der kalten Oberfläche (412) angeordnet ist, und die zweite Wärmesenke sich in dem Wärmeabführluftkanal (17) befindet und mit der heißen Oberfläche (411) verbunden ist.

7. Drahtloses Ladegerät (100) nach einem der Ansprüche 1 bis 6, wobei das Gehäuse (10) einen Körper (11) und eine Basis (12) umfasst, ein Boden des Körpers (11) mit der Basis (12) verbunden ist, eine Oberfläche des Körpers (11), die zu der zu ladenden Vorrichtung (200) weist, die Wärmeabführoberfläche (111) ist, die Basis (12) eine Auflageoberfläche (121) umfasst, die mit der Wärmeabführoberfläche (111) verbunden ist, und die Auflageoberfläche (121) mit einer Perforation (125) ausgestattet ist, und
das Kontaktteil (31) sich von einem oberen Bereich des Körpers zu dem Boden des Körpers erstreckt, das Kontaktteil (31) die Perforation (125) durchläuft, das Kontaktteil (31) mit dem Verbindungsteil (32) verbunden ist, das sich innerhalb der Basis (12) befindet, und das Kontaktteil (31) und das Verbindungsteil (32) in einem Winkel angeordnet sind.

8. Drahtloses Ladegerät (100) nach Anspruch 7, wobei der Körper in der Lage ist, relativ zu der Basis (12) zu rotieren und das Kontaktteil (31) anzutreiben, so dass es relativ zu dem Verbindungsteil (32) gebogen wird.

9. Drahtloses Ladegerät (100) nach Anspruch 7, wobei ein erster Unterbringungsraum (112), der mit dem ersten Lufteinlass (13) kommuniziert, in dem Körper (11) angeordnet ist, ein zweiter Unterbringungsraum (124), der mit dem ersten Unterbringungsraum (112) kommuniziert, in der Basis (12) angeordnet ist, und das Verbindungsteil (32), die Schaltplatinenkomponente (20), die Wärmeabführstruktur (40) und die Wärmeleitstruktur (30) sich alle in dem zweiten Unterbringungsraum (124) befinden,
der erste Lufteinlass (13) sich auf der Wärmeabführoberfläche (111) befindet, der Wärmeabführluftkanal (17) sich von dem ersten Unterbringungsraum (112) zu dem zweiten Unterbringungsraum (124) erstreckt, und der erste Luftauslass (15) sich auf einer Seitenoberfläche der Basis (12) befindet; und
das drahtlose Ladegerät (100) des Weiteren ein erstes Gebläse (60) umfasst, wobei das erste Gebläse (60) sich in dem ersten Unterbringungsraum (112) befindet und dem ersten Lufteinlass (13) entspricht, und wobei Luft, die durch den ersten Lufteinlass (13) in den Wärmeabführluftkanal (17) eintritt, durch das erste Gebläse (60) angetrieben wird, um durch den ersten Luftauslass (15) herauszufließen, um Wärme für eine rückwärtige Oberfläche der zu ladenden Vorrichtung (200) abzuführen, wobei die rückwärtige Oberfläche der zu ladenden Vorrichtung (200) eine Oberfläche ist, die zu der Wärmeabführoberfläche (111) weist.

10. Drahtloses Ladegerät (100) nach Anspruch 9, wobei der zweite Lufteinlass (14) sich auf einer Bodenoberfläche der Basis (12) befindet, der Kühlluftkanal (18) in dem zweiten Unterbringungsraum (124) gebildet ist, und der zweite Luftauslass (16) sich auf der Auflageoberfläche der Basis (12) befindet; und
das drahtlose Ladegerät (100) des Weiteren ein zweites Gebläse (70) umfasst, wobei das zweite Gebläse (70) sich in dem zweiten Unterbringungsraum (124) befindet und dem zweiten Lufteinlass (14) entspricht, und das zweite Gebläse und die erste Wärmesenke zusammenwirken, so dass Luft, die durch den zweiten Lufteinlass (14) in den zweiten Unterbringungsraum eintritt, gekühlt wird und dann durch den zweiten Luftauslass (16) herausfließt, um Wärme für eine Frontoberfläche der zu ladenden Vorrichtung (200) abzuführen, wobei die Frontoberfläche der zu ladenden Vorrichtung (200) eine Oberfläche ist, die von der Wärmeabführoberfläche (111) weg weist.

11. Drahtloses Ladegerät (100) nach Anspruch 9, wobei die Wärmeabführstruktur (40) des Weiteren eine Spulenkomponente (50) umfasst, die Spulenkomponente (50) sich innerhalb des ersten Unterbringungsraums (112) befindet, und eine orthogonale Projektion der Spulenkomponente (50) auf die Wärmeabführoberfläche (111) in einen Bereich einer orthogonalen Projektion einer Spaltregion zwischen dem ersten Seitenteil und dem zweiten Seitenteil auf der Wärmeabführoberfläche (111) fällt.

12. Drahtloses Ladegerät (100) nach Anspruch 9, wobei das drahtlose Ladegerät (100) des Weiteren eine Rippe umfasst und die Rippe sich auf einer Innenwand des ersten Unterbringungsraums und/oder einer Innenwand des zweiten Unterbringungsraums befindet.

## Revendications

1. Chargeur sans fil (100), le chargeur sans fil comprenant :
un boîtier (10), dans lequel le boîtier présente une première entrée d'air (13), une première sortie d'air (15), une seconde entrée d'air (14) et une seconde sortie d'air (16), un canal d'air de dissipation thermique (17) qui communique avec la première entrée d'air (13) et la première sortie d'air (15) et qui est situé à l'intérieur du boîtier étant formé entre la première entrée d'air (13) et la première sortie d'air (15), et un canal d'air de refroidissement (18) qui est conçu pour communiquer avec la seconde entrée d'air (14) et la seconde sortie d'air (16) et qui est situé à l'intérieur du boîtier (10) est formé entre la seconde entrée d'air (14) et la seconde sortie d'air (16) ;
un composant de carte de circuit imprimé (20), dans lequel le composant de carte de circuit imprimé (20) est situé dans le canal d'air de dissipation thermique (17) ;
une structure de conduction thermique (30), dans lequel la structure de conduction thermique (30) comprend une partie de contact (31) et une partie de raccordement (32) qui sont raccordées l'une à l'autre, au moins une partie de la partie de contact (31) est exposée à une surface externe du boîtier (101), la partie de contact (31) est conçue pour être en contact avec un dispositif à charger (200), la partie de raccordement (32) est située à l'intérieur du boîtier (10) et est en contact avec le canal d'air de dissipation thermique (17), la partie de contact (31), la surface externe du boîtier (101) et le dispositif à charger (200) sont conçus pour coopérer afin de former un canal de ventilation (80), et le canal de ventilation (80) est conçu pour communiquer avec le canal d'air de dissipation thermique (17) ;
une structure de dissipation thermique (40), dans lequel la structure de dissipation thermique (40) est située dans le canal d'air de dissipation thermique (17) et est raccordée à la partie de raccordement (32), la structure de dissipation thermique (30) est adjacente au composant de carte de circuit imprimé (20), et la structure de conduction de chaleur (30) est conçue pour conduire la chaleur ; et
dans lequel le canal d'air de dissipation thermique (17) et le canal d'air de refroidissement (18) sont respectivement situés sur deux côtés opposés de la partie de contact (31) de la structure de conduction thermique (30).

2. Chargeur sans fil (100) selon la revendication 1, dans lequel la partie de contact (31) comprend une surface de conduction thermique (311) qui est en contact avec le dispositif à charger (200), et il existe une différence de hauteur entre la surface de conduction thermique (311) et la surface externe du boîtier (101).

3. Chargeur sans fil (100) selon la revendication 1, dans lequel le boîtier (10) comprend une surface de dissipation thermique (111) qui fait face au dispositif à charger (200), la partie de contact (31) comprend une première partie latérale (312) et une seconde partie latérale (313), la première partie latérale (312) et la seconde partie latérale (313) sont en saillie à partir de la surface de dissipation thermique (111) et sont respectivement situées sur deux côtés de la surface de dissipation thermique (111), et un espace est disposé entre la première partie latérale (312) et la seconde partie latérale (313).

4. Chargeur sans fil (100) selon l'une quelconque des revendications 1 à 3, dans lequel la partie de contact (31) et la partie de raccordement (32) sont une structure d'un seul tenant, et la structure d'un seul tenant est flexible.

5. Chargeur sans fil (100) selon l'une quelconque des revendications 1 à 3, la structure de dissipation thermique (40) comprend un élément de refroidissement à semi-conducteur et un premier dissipateur thermique, l'élément de refroidissement à semi-conducteur comprend une surface froide (412), et le premier dissipateur thermique est situé entre la surface froide (412) et la partie de contact (31).

6. Chargeur sans fil (100) selon la revendication 5, dans lequel la structure de dissipation thermique (40) comprend en outre un second dissipateur thermique, l'élément de refroidissement à semi-conducteur comprend en outre une surface chaude (411) disposée à l'opposé de la surface froide (412), et le second dissipateur thermique est situé dans le canal d'air de dissipation thermique (17) et est raccordé à la surface chaude (411).

7. Chargeur sans fil (100) selon l'une quelconque des revendications 1 à 6, dans lequel le boîtier (10) comprend un corps (11) et une base (12), un fond du corps (11) est raccordé à la base (12), une surface du corps (11) qui fait face au dispositif à charger (200) est la surface de dissipation thermique (111), la base (12) comprend une surface d'appui (121) raccordée à la surface de dissipation thermique (111), et la surface d'appui (121) est pourvue d'une perforation (125) ; et
la partie de contact (31) s'étend d'un haut du corps à un bas du corps, la partie de contact (31) passe à travers la perforation (125), la partie de contact (31) est raccordée à la partie de raccordement (32) située à l'intérieur de la base (12), et la partie de contact (31) et la partie de raccordement (32) sont disposées selon un angle.

8. Chargeur sans fil (100) selon la revendication 7, dans lequel le corps est susceptible de tourner par rapport à la base (12) et d'amener la partie de contact (31) à fléchir par rapport à la partie de raccordement (32).

9. Chargeur sans fil (100) selon la revendication 7, dans lequel le premier espace d'accueil (112) communiquant avec la première entrée d'air (13) est disposé dans le corps (11), le second espace d'accueil (124) communiquant avec le premier espace d'accueil (112) est disposé dans la base (12), et la partie de raccordement (32), le composant de carte de circuit imprimé (20), la structure de dissipation thermique (40) et la structure de conduction de chaleur (30) sont tous situés dans le second espace d'accueil (124) ;
la première entrée d'air (13) est située sur la surface de dissipation thermique (111), le canal d'air de dissipation thermique (17) s'étend du premier espace d'accueil (112) au second espace d'accueil (124), et la première sortie d'air (15) est située sur une surface latérale de la base (12) ; et
le chargeur sans fil (100) comprend en outre un premier ventilateur (60), le premier ventilateur (60) est situé dans le premier espace d'accueil (112) et correspond à la première entrée d'air (13), et l'air qui pénètre dans le canal d'air de dissipation thermique (17) par la première entrée d'air (13) est amené par le premier ventilateur (60) à s'écouler par la première sortie d'air (15) afin de dissiper la chaleur pour une surface arrière du dispositif à charger (200), dans lequel la surface arrière du dispositif à charger (200) est une surface qui fait face à la surface de dissipation thermique (111).

10. Chargeur sans fil (100) selon la revendication 9, dans lequel la seconde entrée d'air (14) est située sur une surface inférieure de la base (12), le canal d'air de refroidissement (18) est formé dans le second espace d'accueil (124), et la seconde sortie d'air (16) est située sur la surface d'appui de la base (12) ; et
le chargeur sans fil (100) comprend en outre un second ventilateur (70), le second ventilateur (70) est situé dans le second espace d'accueil (124) et correspond à la seconde entrée d'air (14), et le second ventilateur et le premier dissipateur thermique coopèrent, de sorte que l'air qui entre dans le second espace d'accueil par la seconde entrée d'air (14) soit refroidi et s'écoule ensuite par la seconde sortie d'air (16) pour dissiper la chaleur pour une surface avant du dispositif à charger (200), dans lequel la surface avant du dispositif à charger (200) est une surface qui ne fait pas face à la surface de dissipation thermique (111).

11. Chargeur sans fil (100) selon la revendication 9, dans lequel la structure de dissipation thermique (40) comprend en outre un composant de bobine (50), le composant de bobine (50) est situé à l'intérieur du premier espace d'accueil (112), et une projection orthogonale du composant de bobine (50) sur la surface de dissipation thermique (111) s'inscrit dans une plage d'une projection orthogonale d'une région d'écart entre la première partie latérale et la seconde partie latérale sur la surface de dissipation thermique (111).

12. Chargeur sans fil (100) selon la revendication 9, dans lequel le chargeur sans fil (100) comprend en outre une ailette, et l'ailette est située sur une paroi interne du premier espace d'accueil et/ou une paroi interne du second espace d'accueil.
